# EUROPEAN PATENT APPLICATION

(11) **EP 3 226 310 A1**
(43) Date of publication of application: **04.10.2017**
(21) Application number: 15748152.4
(22) Date of filing: 15.02.2015
(51) Int. Cl.: H01L 31/18, H01L 31/0368

(54) **THIN-FILM SOLAR CELL MANUFACTURING METHOD AND THIN-FILM SOLAR CELL**

(30) Priority: 13.11.2014 CN 201410641467
(71) Applicant: BOE Technology Group Co., Ltd., Beijing 100015 (CN)
(72) Inventor: REN, Qingrong, Beijing 100176 (CN); WANG, Lu, Beijing 100176 (CN); GUO, Wei, Beijing 100176 (CN)
(74) Representative: Lavoix
(86) International application number: PCT/CN2015/073107
(87) International publication number: WO 2016/074368

(57) **Abstract**

The present disclosure provides a method for manufacturing a thin-film solar cell, and the thin-film solar cell. The method includes steps of: forming a first electrode on a substrate; forming an N-type doped layer and an intrinsic semiconductor film on the first electrode; doping ions into the intrinsic semiconductor film, and subjecting the ion-doped intrinsic semiconductor film to activation treatment using an excimer laser annealing (ELA) process, so as to form a P-type doped layer at an upper layer of the intrinsic semiconductor film; and forming a second electrode on the P-type doped layer.

## Description

### CROSS-REFERENCE TO RELATED APPLICATION

The present application claims a priority of the Chinese patent application No.201410641467.4 filed on November 13, 2014, which is incorporated herein by reference in its entirety.

### TECHNICAL FIELD

The present disclosure relates to the field of solar cells, in particular to a method for manufacturing a thin-film solar cell, and the thin-film solar cell.

### BACKGROUND

Currently, thin-film solar cells have become a hotspot of research in the solar cell field due to its advantages such as low material consumption, low production cost, being flexible, high power-to-weight ratio and being light.

During the manufacture of an existing thin-film solar cell, usually an N-type doped layer and an intrinsic a-Si film are formed by plasma enhanced chemical vapor deposition (PECVD), and then a P-type doped layer is formed. Generally, an existing PECVD device does not include a B₂H₆ (diborane) source desired for forming the P-type doped layer, so ions may merely be doped into an upper layer of the intrinsic a-Si film using an ion doping device after the intrinsic a-Si film is formed, so as to form the P-type B⁺-doped layer. However, the doped B⁺ is inactive, and it is required to activate the B⁺ at a high temperature (e.g., in a high-temperature furnace). Usually, a substrate (particularly a flexible substrate) of the thin-film solar cell cannot be subjected to, and thus will be deformed at, the high temperature, which results in a reduced yield of the thin-film solar cell.

### SUMMARY

An object of the present disclosure is to provide a method for manufacturing a thin-film solar cell and the thin-film solar cell, so as to prevent a substrate of the thin-film solar cell from being damaged due to an activation process at a high temperature, thereby to improve a yield of the thin-film solar cell.

In one aspect, the present disclosure provides in one embodiment a method for manufacturing a thin-film solar cell, including steps of:
forming a first electrode on a substrate;
forming an N-type doped layer and an intrinsic semiconductor film on the first electrode;
doping ions into the intrinsic semiconductor film, and subjecting the ion-doped intrinsic semiconductor film to activation treatment using an excimer laser annealing (ELA) process, so as to form a P-type doped layer at an upper layer of the intrinsic semiconductor film; and
forming a second electrode on the P-type doped layer.

Alternatively, the N-type doped layer and the intrinsic semiconductor film are formed by PECVD.

Alternatively, the ions are doped into the intrinsic semiconductor film using B₂H₆.

Alternatively, the intrinsic semiconductor film is of a thickness of about 0.8µm to 1.2µm.

Alternatively, the ions are doped into the intrinsic semiconductor film in a depth range of about 30nm to 50nm.

Alternatively, the method further includes forming an antireflection layer on the P-type doped layer.

Alternatively, the intrinsic semiconductor film is an a-Si semiconductor layer or a poly-Si semiconductor film.

Alternatively, the substrate is a flexible substrate.

In another aspect, the present disclosure provides in one embodiment a thin-film solar cell manufactured by the above-mentioned method. The thin-film solar cell includes a substrate, and a first electrode, an N-type doped layer, an intrinsic semiconductor layer, a P-type doped layer and a second electrode arranged sequentially on the substrate.

In yet another aspect, the present disclosure provides in one embodiment a thin-film solar cell, including a substrate, and a first electrode, an N-type doped layer, an intrinsic semiconductor layer, a P-type doped layer and a second electrode arranged sequentially on the substrate. The intrinsic semiconductor layer and the P-type doped layer are obtained by subjecting an ion-doped intrinsic semiconductor film to activation treatment using an excimer laser annealing process.

Alternatively, the intrinsic semiconductor film is an a-Si semiconductor film or a poly-Si semiconductor film.

Alternatively, the ions are doped into the intrinsic semiconductor film using B₂H.

Alternatively, the ion-doped intrinsic semiconductor film is of a thickness of about 30nm to 50nm.

Alternatively, the first electrode includes a plurality of strip-like sub-electrodes arranged parallel to each other.

Alternatively, the second electrode includes a plurality of strip-like sub-electrodes arranged parallel to each other, and the sub-electrodes of the first electrode intersect the sub-electrodes of the second electrode at right angles.

Alternatively, the thin-film solar cell further includes an antireflection layer formed on the P-type doped layer.

Alternatively, the antireflection layer includes a plurality of antireflective strips arranged parallel to each other, and the antireflective strips and the sub-electrodes of the second electrode are arranged alternately.

Alternatively, the substrate is a flexible substrate.

According to the embodiments of the present disclosure, a region to be treated may be accurately controlled by the ELA process, and merely the intrinsic semiconductor film at the region for forming the P-type doped layer is heated rapidly at a relatively large temperature gradient. As a result, it is able to prevent the substrate of the thin-film solar cell from being damaged, thereby to prevent the substrate of the thin-film solar cell from being deformed due to a high temperature and improve a yield of the thin-film solar cell.

### BRIEF DESCRIPTION OF THE DRAWINGS

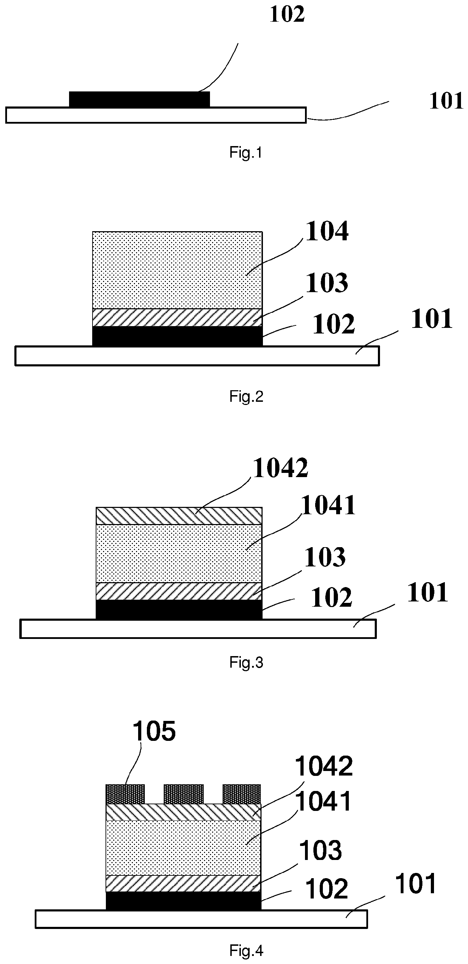

Figs.1-5 are flow charts of a method for manufacturing a thin-film solar cell according to one embodiment of the present disclosure.

### DETAILED DESCRIPTION

In order to make the objects, the technical solutions and the advantages of the present disclosure more apparent, the present disclosure will be described hereinafter in conjunction with the drawings and embodiments.

The present disclosure provides in one embodiment a method for manufacturing a thin-film solar cell, which includes a step of forming a P-type doped layer of the thin-film solar cell through ion-doping and activation treatment. An ELA process is used in the activation treatment.

A region to be treated may be accurately controlled by the ELA process, and merely the intrinsic semiconductor film at a region for forming the P-type doped layer is heated rapidly at a relatively large temperature gradient. As a result, it is able to prevent a substrate of the thin-film solar cell from being damaged, thereby to prevent the substrate of the thin-film solar cell from being deformed due to a high temperature and improve a yield of the thin-film solar cell.

Referring to Figs.1-5, the method may include the following steps.

Step S11: referring to Fig.1, forming a first electrode 102 on a substrate 101. To be specific, the first electrode 102 may include a plurality of strip-like sub-electrodes arranged parallel to each other, and it may be made of a metal such as Mo and serve as a lower electrode of the thin-film solar cell.

Step S12: referring to Fig.2, forming an N-type doped layer and an intrinsic semiconductor film 104 on the first electrode 102. To be specific, the N-type doped layer 103 and the intrinsic semiconductor film 104 may be formed by a depositing process, e.g., PECVD or low pressure chemical vapor deposition (LPCVD). The intrinsic semiconductor film 104 may be an a-Si film or a poly-Si film. Alternatively, the N-type doped layer 103 may be of a thickness of about 30nm to 50nm, and the intrinsic semiconductor film 104 may be of a thickness of about 0.8µm to 1.2µm, e.g. 1µm.

Step S13: referring to Fig.3, doping ions into the intrinsic semiconductor film 104 and subjecting the ion-doped intrinsic semiconductor film to activation treatment using an ELA process, so as to form a P-type doped layer 1042 at an upper layer of the intrinsic semiconductor film and cause a lower layer of the intrinsic semiconductor film 104 to serve as an intrinsic semiconductor layer 1041. To be specific, the ions may be doped into the intrinsic semiconductor film 104 using B₂H₆. Alternatively, the ions may be doped into the intrinsic semiconductor film 104 in a depth range of about 30nm to 50nm.

To be specific, for the ELA process, the ion-doped intrinsic semiconductor film may be exposed to a laser beam with an appropriate energy density. The laser beam used in the ELA process may be, for example, a XeCI laser beam, an ArF laser beam, a KrF laser beam or an XeF laser beam. Different light beams may be generated by different molecules, and the output energy density may be adjusted in accordance with the thickness of the ion-doped intrinsic semiconductor film 104.

Relevant parameters involved in the activation treatment of the B⁺-doped intrinsic a-Si film using the ELA process are shown in the following table, where Split represents a serial number of a sample, ELA (0.01 mm, 300Hz) represents a traveling distance of the sample within each pulse and a frequency of a laser, ATT represents an attenuator, Energy represents the energy of the laser beam, Energy Density represents the energy density of the laser beam, and Doping 1 (80KV, 4µA/cm², 1E+16, 40sccm, B₂H₆(10%)) represents an accelerating voltage, a current density, a doping dose, a gas flow rate and a doping gas, respectively.

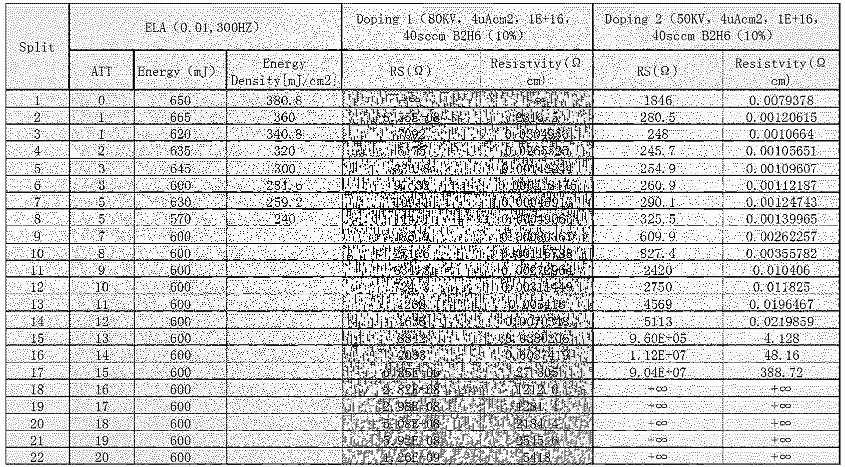

Step S14: referring to Fig.4, forming a second electrode 105 on the P-type doped layer 1042. To be specific, the second electrode 105 may include a plurality of strip-like sub-electrodes arranged parallel to each other, and it may be made of a conductive material such as Mo, indium tin oxide (ITO) or Cu and serve as an upper electrode of the thin-film solar cell. The sub-electrodes of the first electrode 102 intersect the sub-electrodes of the second electrode 105 at right angles.

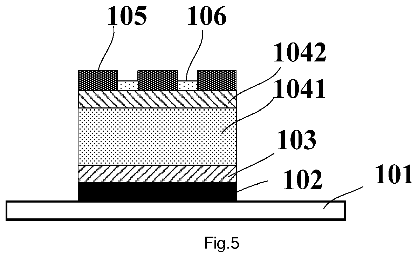

Step S15: referring to Fig.5, forming an antireflection layer 106 on the P-type doped layer 1042. To be specific, the antireflection layer 106 includes a plurality of antireflective strips arranged parallel to each other, and the antireflective strips and the sub-electrodes of the second electrode 105 are arranged alternately. The antireflection layer 106 is arranged so as to increase the photovoltaic conversion efficiency, and it may be made of a material such as SiOx.

Through the above-mentioned method, it is able to subject the ion-doped intrinsic semiconductor film to the activation treatment using the ELA process, and merely a predetermined region at a surface of the intrinsic semiconductor film is exposed to the short-time pulse laser used in the ELA process. Hence, it is able to maintain the substrate of the thin-film solar cell at a low temperature and prevent it from being damaged. The above-mentioned method is particularly adapted to a flexible thin-film solar cell with a flexible substrate.

The present disclosure further provides in one embodiment a thin-film solar cell manufactured by the above-mentioned method. The thin-film solar cell includes a substrate, and a first electrode, an N-type doped layer, an intrinsic semiconductor layer, a P-type doped layer and a second electrode arranged sequentially on the substrate.

The first electrode may include a plurality of strip-like sub-electrodes arranged parallel to each other, the second electrode may include a plurality of strip-like sub-electrodes, and the sub-electrodes of the first electrode intersect the sub-electrodes of the second electrode at right angles.

Alternatively, the thin-film solar cell may further include an antireflection layer arranged on the P-type doped layer. The antireflection layer includes a plurality of antireflective strips arranged parallel to each other, and the antireflective strips and the sub-electrodes of the second electrode are arranged alternately.

The above are merely the preferred embodiments of the present disclosure. It should be appreciated that, a person skilled in the art may make further modifications and improvements without departing from the principle of the present disclosure, and these modifications and improvements shall also fall within the scope of the present disclosure.

## Claims

1. A method for manufacturing a thin-film solar cell, comprising steps of:
forming a first electrode on a substrate;
forming an N-type doped layer and an intrinsic semiconductor film on the first electrode;
doping ions into the intrinsic semiconductor film, and subjecting the ion-doped intrinsic semiconductor film to activation treatment using an excimer laser annealing (ELA) process, so as to form a P-type doped layer at an upper layer of the intrinsic semiconductor film; and
forming a second electrode on the P-type doped layer.

2. The method according to claim 1, wherein the N-type doped layer and the intrinsic semiconductor film are formed by plasma enhanced chemical vapor deposition (PECVD).

3. The method according to claim 1 or 2, wherein the ions are doped into the intrinsic semiconductor film using B₂H₆.

4. The method according to any one of claims 1 to 3, wherein the intrinsic semiconductor film is of a thickness of about 0.8µm to 1.2µm.

5. The method according to any one of claims 1 to 4, wherein the ions are doped into the intrinsic semiconductor film in a depth range of about 30nm to 50nm.

6. The method according to any one of claims 1 to 5, further comprising forming an antireflection layer on the P-type doped layer.

7. The method according to any one of claims 1 to 6, wherein the intrinsic semiconductor film is an a-Si semiconductor layer or a poly-Si semiconductor film.

8. The method according to any one of claims 1 to 7, wherein the substrate is a flexible substrate.

9. A thin-film solar cell manufactured by the method according to any one of claims 1 to 8, comprising a substrate, a first electrode, an N-type doped layer, an intrinsic semiconductor layer, a P-type doped layer and a second electrode which are arranged sequentially.

10. A thin-film solar cell, comprising a substrate, a first electrode, an N-type doped layer, an intrinsic semiconductor layer, a P-type doped layer and a second electrode which are arranged sequentially, wherein the intrinsic semiconductor layer and the P-type doped layer are obtained by subjecting an ion-doped intrinsic semiconductor film to activation treatment using an excimer laser annealing process.

11. The thin-film solar cell according to claim 10, wherein the intrinsic semiconductor film is an a-Si semiconductor film or a poly-Si semiconductor film.

12. The thin-film solar cell according to claim 10 or 11, wherein the ions are doped into the intrinsic semiconductor film using B₂H.

13. The thin-film solar cell according to claim 12, wherein the ion-doped intrinsic semiconductor film is of a thickness of about 30nm to 50nm.

14. The thin-film solar cell according to any one of claims 10 to 13, wherein the first electrode comprises a plurality of strip-like sub-electrodes arranged parallel to each other.

15. The thin-film solar cell according to any one of claims 10 to 14, wherein the second electrode comprises a plurality of strip-like sub-electrodes arranged parallel to each other, and the sub-electrodes of the first electrode intersect the sub-electrodes of the second electrode at right angles.

16. The thin-film solar cell according to any one of claims 10 to 15, further comprising an antireflection layer formed on the P-type doped layer.

17. The thin-film solar cell according to claim 16, wherein the antireflection layer comprises a plurality of antireflective strips arranged parallel to each other, and the antireflective strips and the sub-electrodes of the second electrode are arranged alternately.

18. The thin-film solar cell according to any one of claims 10 to 17, wherein the substrate is a flexible substrate.
